**Europäisches Patentamt**

**European Patent Office**

**Office européen des brevets**

(11) Veröffentlichungsnummer: **0 207 300 B1**

(12) **EUROPÄISCHE PATENTSCHRIFT**

(45) Veröffentlichungstag der Patentschrift:
**08.11.89**

(51) Int. Cl.⁴: **C 30 B 21/02, C 30 B 29/62, C 30 B 33/00, C 30 B 3/00**

(21) Anmeldenummer: **86107406.0**

(22) Anmeldetag: **31.05.86**

(54) **Verfahren zur Herstellung oxidkeramischer Körper mit hohem Verhältnis von Oberfläche zur Masse und hoher Festigkeit.**

(30) Priorität: **04.06.85 DE 3519932**

(43) Veröffentlichungstag der Anmeldung:
**07.01.87 Patentblatt 87/2**

(45) Bekanntmachung des Hinweises auf die Patenterteilung:
**08.11.89 Patentblatt 89/45**

(84) Benannte Vertragsstaaten:
**CH DE FR GB IT LI NL SE**

(56) Entgegenhaltungen:
**DE-A- 1 964 991**
**US-A- 3 533 863**

(73) Patentinhaber: **Erkens, Herbert E., Dipl.-Ing., An der Esche 8, D-4050 Mönchengladbach 2 (DE)**

(72) Erfinder: **Der Erfinder hat auf seine Nennung verzichtet**

(74) Vertreter: **König, Werner, Dipl.-Ing., Habsburgerallee 23-25, D-5100 Aachen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Herstellung oxidkeramischer, einkristalliner und/oder sich aus Einkristallen zusammensetzender in sich verbundener Körper.

Die nach einem solchen Verfahren hergestellten Fasern, Einzelplatten bzw. Lamellen weisen dabei die Besonderheit auf, daß sie in Längsrichtung nur aus einem Einkristall, d.h. aus Material mit gleichbleibender Kristall-Orientierung, bestehen. Sie weisen deshalb eine hohe Festigkeit in dieser Richtung auf. Außerdem besitzen sie ein großes Verhältnis Oberfläche/Keramikmasse und im Fall der mehrkristallinen Körper eine hohe Verbindungsfestigkeit der Einkristalle untereinander durch Zwillingsbildung, so daß sie vornehmlich als Füllstoff zur Versteifung von Kunststoffbauteilen aus spritzgegossenen, als Schlicker gegossenen, gepreßten oder auf eine der anderen bekannten Weisen hergestellten organischen oder anorganischen Materialien geeignet sind.

Es ist bekannt, daß man Kunststoffe mit Hilfe von keramischen Füllstoffen versteifen kann. Beispielsweise benutzt man häufig Schiefermehl zur Füllung von Kunstharzen, um damit komplizierte Formteile, wie z.B. Werkzeuge, abzubilden. Die dazu verwendeten Pulver werden überwiegend durch Mahlen grober Ausgangsmaterialien hergestellt. Dabei entstehen splittrige Körner verschiedenster Größe.

Ein weiteres übliches Verfahren zur Herstellung besonders feinkörnig abgerundeter Keramik-Pulver besteht darin, ein wasserlösliches Salz zu hydrolysieren und das Wasser nach und nach durch Erwärmen zu vertreiben.

Beispielsweise kann man so aus Zirkonoxichlorid Zirkondioxid mit Korngrößen von bis zu 0,1 μm Durchmesser herstellen.

Ähnliche und weitere Verfahren sind bekannt, nach denen Feinstkorn-Material, z.B. zur Herstellung von Farb-Pigmenten, erhalten wird.

Es ist weiterhin nach Maßgabe des japanischen Patents JA 58 185 435 (Chemical Abstracts, Vol. 100, 1984, 88084x) Stand der Technik, $\alpha$ -$Al_2O_3$-Fasern ausgehend von einem Aluminiumhydroxisulfat-Hydrat durch Brennen herzustellen. Die Fasern sollen Durchmesser von 0,1 bis 1 μm und Längen/Durchmesser-Verhältnisse von mehr als 20 aufweisen. Es ist aber bekannt, daß diese Fasern immer einen geringen Anteil an Siliziumdioxid aufweisen, welches als Binder und Sinterhilfsmittel zur Herstellung notwendig ist, und die Fasern außerdem sich in Längsrichtung aus unterschiedlich orientierten Kristallen zusammensetzen. Dementsprechend ist die Zugfestigkeit dieser Fasern um Größenordnungen geringer als die von beispielsweise Kohlenstofffasern. Die theoretische Zugfestigkeit von reinen $\alpha$-Aluminiumoxid-Whiskern mit 1 μm Durchmesser beträgt beispielsweise mehr als 10.000 $N/mm^2$.

Zwei plattenförmige Einkristalle sind dann besonders fest miteinander verbunden, wenn die Verbindungsstelle aus einer Durchdringungs-Zwillingsbildung besteht, was nur durch gleichzeitiges Wachstum der Kristalle erreicht werden kann. Dies kann beispielsweise manchmal bei der Züchtung von Einkristallen nach dem CVD-Verfahren (chemische Abscheidung aus der Gasphase) beobachtet werden. Der Nachteil des CVD-Verfahrens, mit welchem überwiegend stengelförmige Einkristalle erzeugt werden, ist es aber, daß es sehr kostenintensiv und damit zur Herstellung größerer Mengen an keramischen Füllstoffen ungeeignet ist. Es werden dabei weiterhin die Pulver bzw. Stengelkristallite durch mechanisches Ablösen von einem Substrat mit unterschiedlichstem Aussehen, d.h. mit unterschiedlichem Längen-zu-Durchmesser-Verhältnis ( = 100), gewonnen, die zur Versteifung von Kunststoffbauteilen wenig geeignet sind.

Es ist nun weiterhin bekannt, daß man Whisker aus Karbiden und Boriden als Verstärkung von metallischen Legierungen mit Methoden und Verfahren der «gerichteten Erstarrung» herstellen kann. Z.B. KURZ, W. und SAHM, P.R., «Gerichtet erstarrte eutektische Werkstoffe», Springer Verlag Berlin (1975), beschreiben die einsetzbaren Verfahren. Die Whisker verbleiben in den gerichtet erstarrten Legierungen. Eine Herausätzung ist zwar möglich, aber zur Herstellung großer Mengen zu kostenintensiv. Die Whisker besitzen höhere Zugfestigkeiten als die verwendeten Legierungen (überwiegend Nickelbasislegierungen).

Eine größere Zahl von Verfahren zur Herstellung von mehrkristallinen Fasern und Whiskern wird in einer Studie der Kommission der Europäischen Gemeinschaften, BRACKE, P., «Inorganic fibres & composit materials» (EPO applied technology Series, No. 3) ISBN 0-08 031 145-8 (1984), beschrieben.

Dabei werden überwiegend oxidische Fasern und Whisker aus ihren eigenen Schmelzen bei Temperaturen von mehr als 1300°C oder auch aus Schmelzen der Salze von Oxisäuren (z.B. Sulfate) bei tieferen Temperaturen gewonnen. Im letzteren Fall führt man chemische Reaktionen, z.B. Hydrolysen mit Wasserdampf, durch, wobei Säuren oder Säurereste bei mehr als 600°C freigesetzt werden.

Beispielsweise wird in US 3 711 599 und US 3 875 296 ein Verfahren beschrieben, bei dem ein Schmelzfilm, der ein Nickelsalz und mindestens ein Hilfesalz aus der Reihe der Alkalimetallchloride, -bromide oder -sulfate oder des Kalzium-, Barium- oder Strontiumchlorids enthält, mit Wasserdampf bei 700°C bis 1200°C umgesetzt wird. Auf diese Weise wird eine Säure oder ein Säurerest, wie hier Chlorwasserstoff bzw. Schwefeltrioxid, freigesetzt. Gleichzeitig wird Nickeloxid in der übersättigten Schmelze erzeugt, welches dort die Fasern bildet.

Dieses Verfahren hat den Nachteil, daß man wegen der Luftfeuchtigkeit und des in der Luft vorhandenen Kohlendioxids unter Schutzgas arbeiten muß, sonst würde die Hydrolyse unkontrolliert schon bei der Herstellung der Schmelze und vorher einsetzen und die ätzenden Stoffe an die Umgebung abgeben. Die Hydrolyse tritt auch bei der anschließenden Auflösung der Salze auf, so daß das Produkt nicht direkt in reiner Form erhalten wird. Die notwendige Kapselung des Prozesses sowie die Notwendigkeit der Wiedergewinnung und Konzentrierung der freigesetzten Stoffe zur Vermeidung von Umweltschäden und auch die hohe korrosive Wirkung der freigesetzten Stoffe auf die metallischen Werkstoffe sind die Nachteile des Verfahrens.

Aufgabe dieser Erfindung ist es daher, ein Verfahren zur Herstellung von Körpern zu schaffen, welche aus einem oder mehreren weitestgehend reinen Oxiden bestehen, bei denen nur Salze verwendet werden, die chemisch an Luft und gegenüber Lösungsmitteln bei allen Prozeßbedingungen stabil sind, wobei die Salze aber nach der Erstarrung mit Hilfe eines Lösungsmittels vom Produkt abgetrennt und wiederverwendet werden können.

Die gestellte Aufgabe wird dadurch gelöst, daß ein oder mehrere oxidische Materialien, welches bzw. welche ein eutektisches, eutektoides oder peritektisches Phasensystem mit einem oder mehreren der Alkalimetall-Metall- und/oder Erdalkalimetall-Metall-Fluoride bildet bzw. bilden, mit ihm bzw. mit ihnen zusammen mit einem oder mehreren der Erdalkalimetall- und/oder Alkalimetall-Halogeniden in Form des Chlorids und/oder Bromids und/oder Jodids teilweise oder vollständig aufgeschmolzen wird bzw. werden, die gesamte Mischung nicht höher als 1300°C erwärmt und anschließend unter Erstarrung abgekühlt wird, und weiterhin die Halogenide mit Hilfe eines Lösungsmittels abgetrennt werden.

Es wurde nun gefunden, daß die Mischung eines oder mehrerer Oxide mit einem oder mehreren der Alkalimetall- oder Erdalkali-Metall-Fluoride und zusätzlich mit einem oder mehreren der Alkalimetallhalogenide des Chlors, Broms oder Jods die folgenden Randbedingungen für ein Verfahren erfüllt:

— die Mischung ist an Luft auch im Schmelzfluß sowie gegen Wasser als Lösungsmittel chemisch stabil;

— der Zusatz des Alkalimetallhalogenids bewirkt, daß feinste Fluoridpartikel, die nur eine sehr geringe Löslichkeit in Wasser besitzen, durch Auflösen des Alkalihalogenids ausgeschwämmt werden und z.B. mit Hilfe von Filtern definierter Porengröße oder Zentrifugen zusammen mit der wässrigen konzentrierten Halogenidlösung abgetrennt werden können;

— die wässrige Halogenidlösung zusammen mit den Alkalimetall-Metall- oder Erdalkalimetall-Metallfluoriden als aufgeschlämmte Partikel ist durch Eindampfen direkt wiederverwendbar;

— die oxidischen Körper werden in weitestgehend reiner Form erhalten.

Es hat sich in Versuchen gezeigt, daß Kalium- und/oder Natriumfluorid als Alkalimetallhalogenidzusatz nicht geeignet ist, weil diese Substanzen im Schmelzfluß mit dem eingesetzten Oxid reagieren. So erhält man aus einer Schmelze aus Aluminiumoxid, Kryolith und Natriumfluorid nur oxidische Produkte, die $\beta$-A1$_2$O$_3$, also Natriumoxidanteile, enthalten. Dies wird mit Benutzung der Alkalimetall- und/oder Erdalkalimetall -Chloride, -Bromide oder -Jodide vermieden.

Die Benutzung eines oder mehrerer Alkalimetall-Metall-Fluoride zusammen mit dem Oxid und einem oder mehreren der Erdalkalichloride und/oder -bromide und/oder -jodide ist ebenfalls möglich, weil sich die Schmelze aufgrund des Austausches von Kationen dann auch aus den erfindungsgemäßen Stoffen zusammensetzt. Sie sind reziproke Salzpaare, bei denen das Metallfluoridanion chemisch stabil bleibt und sich kein Alkalimetall- oder Erdalkalimetallfluorid bildet.

Es sind erfindungsgemäß nur Alkalimetall-Metall- und/oder Erdalkalimetall-Metallfluoride zu wählen, die ein eutektisches, eutektoides oder auch peritektisches Phasensystem mit dem verwendeten Oxid bilden. Damit erhält man Schmelzen, die trotz des zusätzlichen Anteils der Alkalimetall- und/oder Erdalkalimetallchloride, -bromide und/oder -jodide noch eine hohe Löslichkeit des Oxides aufweisen, so daß ein hoher Anteil der Schmelze als Produkt erhalten wird. Es ist weiterhin erfindungsgemäß möglich, das jeweilige Oxid in einer höheren Konzentration einzusetzen als dies seiner Löslichkeit entspricht. Nicht aufgeschmolzene Oxidpartikel fungieren dann als Keim bei der anschließenden Erstarrung, so daß besonders dünnwandige Platten an den Keimen anwachsen.

Eine höhere Oxidkonzentration als der Löslichkeit entspricht wählt man insbesondere dann, wenn man von einem hochporösen Oxid-Ausgangspulver als Einsatzstoff ausgeht, dessen Porendurchmesser erweitert werden sollen, wobei der in Lösung gegangene Anteil bei der Erstarrung überwiegend platten- oder faserförmig an den porösen Teilchen anwächst.

Gemäß einem weiteren Vorschlag der Erfindung kann das Verfahren so ausgeführt werden, daß die Mischung so hergestellt wird, daß die Kationen der Schmelze zu mehr als 30%-mol aus denen der Alkalimetalle und/oder Erdalkalimetalle bestehen, und die Anionen zu mehr als 20%-mol aus denen des Chlors und/oder Broms und/oder Jods, und weniger als 80%-mol, aber mehr als 5%-mol, aus einem oder mehreren Anionen der Metall-Tri-, -Tetra-, -Penta- und/oder -Hexafluoride bestehen.

Es hat sich gezeigt, daß es zur Erzielung einer besonders hohen Reinheit des oxidischen Produkts günstig ist, einen hohen Anteil des Alkalimetall- und/oder Erdalkalimetallhalogenids und einen geringen Anteil des Alkalimetall-Metall- und/oder Erdalkalimetall-Metallfluorids zu verwenden. Dann ist aber der Anteil des Oxids, welches in der Schmelze in Lösung gebracht werden kann, relativ klein. Diese Vorgehensweise eignet sich deshalb besonders für die Vergrößerung der Poren von $\gamma$-A1$_2$O$_3$ unter Erzeugung von schwammartigem $\alpha$-A1$_2$O$_3$ mit angewachsenen Plättchen aus $\alpha$-A1$_2$O$_3$.

Im Falle der Verwendung hoher Anteile des oder der Alkalimetall-Metall und/oder Erdalkalimetall-Metall-Fluoride erhält man dagegen einen hohen löslichen Oxidanteil in der Schmelze von bis zu 40%-Gewicht unterhalb von 1300°C. In diesem Fall ist es oft notwendig, das filtrierte Produkt mit Hilfe z.B. starker, konzentrierter Säuren, wie Schwefelsäure, nachzubehandeln, um eine hohe Reinheit des Oxids zu erhalten.

Gemäß einem weiteren Vorschlag der Erfindung kann das Verfahren so ausgeführt werden, daß im wesentlichen nur die Kationen des Natriums und/oder des Kaliums verwendet werden. Dabei ergeben sich Vorteile aus Kostengründen und aufgrund der hohen chemischen Stabilität.

Gemäß einem weiteren Vorschlag der Erfindung kann das Verfahren so ausgeführt werden, daß Kalium- und/oder Natriumchlorid im Gewichtsverhältnis zum Kalium-Metall- und/oder Natrium-Metall-Tri- und/oder Tetra- und/oder Penta- und/oder Hexafluorid von 3/2 bis zu 2/3 verwendet wird.

Im Fall des Kryoliths, Natriumchlorids und Aluminiumoxids hat es sich als günstig herausgestellt, die beiden Salze im Gewichtsverhältnis von etwa 1:1 zu verwenden. Man erhält eine hohe Reinheit des oxidischen Produkts und kann z.B. Aluminiumoxid mit bis zu etwa 40%-Gewicht bezogen auf die gesamte Schmelze einsetzen.

Gemäß einem weiteren Vorschlag der Erfindung kann das Verfahren so ausgeführt werden, daß Natrium-Aluminiumhexafluorid (Kryolith) und/oder Kalium-Aluminiumhexafluorid verwendet wird. Dies führt zu einer weiteren Kostensenkung.

Gemäß einem weiteren Vorschlag der Erfindung kann das Verfahren so ausgeführt werden, daß als oxidisches Material Aluminiumoxid und/oder Siliziumoxid und/oder Zirkonoxid und/oder Magnesiumoxid und/oder Kalziumoxid und/oder Titanoxid und/oder Cadmiumoxid und/oder Zinkoxid und/oder Chromoxid und/oder Vanadiumoxid und/oder Wolframoxid und/oder Molybdänoxid verwendet wird bzw. werden.

Das Verfahren eignet sich zur Herstellung von Körpern aus den verschiedensten Oxiden. Es ist so zum einen möglich, aus z.B. Aluminiumoxid und Kryolith technischer Reinheit, Körper herzustellen, die wesentlich reiner sind als das eingesetzte Oxid. Ein großer Teil der Verunreinigungen wird in dem Salzgemisch gefunden und damit nicht in das oxidische Material bei der Erstarrung aufgenommen. Zum anderen kann man auch mehrere Oxide gleichzeitig in der Schmelze lösen und Körper aus Oxid-Verbindungen erhalten.

Mit Hilfe der Regelung der Erstarrungsgeschwindigkeit und des Temperaturgradienten während der Erstarrung läßt sich die Ausbildung der oxidischen Körper steuern.

Gemäß einem weiteren Vorschlag der Erfindung kann das Verfahren so ausgeführt werden, daß die Schmelze abgeschreckt wird, und oxidkeramische, untereinander verbundene Platten, einzelne Lamellen und/oder Fasern erhalten werden, deren Dicke überwiegend weniger als 5 µm, vorzugsweise 0,1 bis 0,2 µm, beträgt und/oder oxidkeramische Körper erhalten werden, die Poren mit Durchmessern von überwiegend bis zu 5 µm aufweisen.

Bei schneller Abkühlung = Abschreckung erhält man je nach Art der verwendeten Salze und Oxide sehr dünnwandige Körper von weniger als 5 µm mit Ausdehnungen von bis zu 30 µm. Bei Abschreckung einer aluminiumoxidhaltigen Schmelze aus Kryolith mit Natriumchlorid werden beispielsweise Körper aus $\alpha$-Al$_2$O$_3$ gefunden, die sich aus etwa 10 bis 50 untereinander mit Winkeln von 60° und 90° verwachsenen, einkristallinen Plättchen zusammensetzen. Die Plättchen haben überwiegend eine Ausdehnung von ca. 10 bis 300 µm$^2$ bei Dicken von etwa 0,2 µm.

Die bevorzugten Methoden, die Schmelze schnell abzukühlen, bestehen in der Verdüsung in einem mit kaltem Gas gefüllten Raum, der Abschreckung in einem Wasserbad oder auch des Gusses der Schmelze zwischen zwei sich drehenden gekühlten Walzen, deren Oberfläche rauh ausgebildet ist und die zwischen sich einen Abstand von etwa 1 mm aufweisen.

Die schnelle Abkühlung wendet man bevorzugt auch auf die Herstellung von porenhaltigen, oxidkeramischen Körpern an, wie am Beispiel der Porenvergrößerung des $\gamma$-Al$_2$O$_3$ schon erläutert wurde.

Gemäß einem weiteren Vorschlag der Erfindung kann das Verfahren so ausgeführt werden, daß die Schmelze mit einem Verhältnis des Temperaturgradienten zur Geschwindigkeit der Erstarrungsfront von mehr als 50°C h/cm$^2$ abgekühlt wird, so daß oxidkeramische Lamellen und/oder Fasern und/oder Whisker beliebiger Länge mit Wanddicken bzw. Durchmessern von überwiegend weniger als 10 µm, vorzugsweise weniger als 1 µm, erhalten werden.

Es wurde gefunden, daß man unter Anwendung der aus der Metallurgie bekannten Methoden der «Gerichteten Erstarrung» auf die erfindungsgemäßen Schmelzen zu oxidischen Körpern gelangt, die eine beliebige Länge aber geringe Dicken aufweisen und die sich in Längsrichtung aus einkristallinem Material zusammensetzen.

Gemäß einem weiteren Vorschlag der Erfindung kann das Verfahren so ausgeführt werden, daß als Lösungsmittel Wasser oder ein wasserähnliches Lösungsmittel verwendet wird. Dabei kann es sich insbesondere um alkoholische und/oder ammoniakalische Mischungen mit Wasser, flüssiges Ammoniak oder flüssiges Schwefeldioxid handeln. Jedenfalls ist die Verwendung billiger Lösungsmittel möglich.

Diese nach dem erfindungsgemäßen Verfahren hergestellten Körper sind besonders zur Bildung von Verbundwerkstoffen, zur Erhöhung der Festigkeit und Feuerfestigkeit von Bauteilen geeignet, beispielsweise und vor allem der von Kunststoff- und Leichtmetallbauteilen.

Die Erfindung wird im folgenden anhand der Ausführungsbeispiele erläutert.

1. Es wurden 1 kg hochporösen $\gamma$-Al$_2$O$_3$-Pulvers auf eine mittlere Korngröße von ca. 20 µm zusammen mit 0,7 kg Kryolith und 0,8 kg Natriumchlorid vermahlen. Die Mischung wurde im Nickeltiegel auf 1070°C erhitzt und im Wasserbad abgeschreckt. Unter Umrühren entstand eine Aufschlämmung, die mit Hilfe eines Filters mit 8 µm Porendurchmesser unter Wasserzugabe und weiterem Rühren filtriert wurde.

Der Filterkuchen wurde getrocknet. Er bestand aus Körpern aus $\alpha$-Al$_2$O$_3$ mit Durchmessern von 10 bis 30 µm, die sich überwiegend aus miteinander verwachsenen Plättchen zusammensetzten, deren Wandstärken ca. 0,1 µm bis 0,2 µm betrugen. Ein kleinerer Anteil der Körper bestand aus Pulverkörnern mit Poren von ca. 1 bis 3 µm, an denen häufig ebenfalls Platten und Teile von Plattenkörpern angewachsen waren.

Die beim Filtrieren gewonnene wässrige Lösung enthielt das Kryolith in Aufschlämmung mit Korndurchmessern von ca. 0,1 bis 1 µm. Durch Eindampfen wurden die Salze wiedergewonnen.

2. Es wurde eine Schmelze aus 3%-Gewicht Al$_2$O$_3$, 64% Natriumchlorid und 33%-Gewicht Kryolith in austenitischen Rohren von 0,5 mm erzeugt. Die Rohre wurden bei 1100°C vom heißen Teil eines Ofens erschütterungsfrei in ein Wasserbad abgesenkt, so daß das Verhältnis des Temperaturgradienten zur Absenkungsgeschwindigkeit etwa 5000°C

h/cm$^2$ betrug. Es wurde im weiteren wie im Beispiel 1 verfahren. Als Produkt wurden gerichtete α-A1$_2$O$_3$-Lamellen mit Breiten von bis zu mehreren 100 μm und vielen Millimetern in der Länge erhalten, die Dicken von ca. 1 bis 5 μm aufwiesen.

3. Es wurde wie im Beispiel 2 verfahren, aber ein Verhältnis des Temperaturgradienten zur Absenkungsgeschwindigkeit von ca. 1500°C h/cm$^2$ eingestellt. Es wurden gerichtete Stengelkristallite mit Durchmessern von etwa 2 μm und einzelne schmale Lamellen mit Dicken von etwa 2 μm aus α-A1$_2$O$_3$ erhalten, die mehrere Millimeter lang waren.

4. Es wurde wie im Beispiel 2 und 3 verfahren, aber ein Verhältnis von 150°C h/cm$^2$ eingestellt. Das Produkt aus α-A1$_2$O$_3$ bestand aus dendritischen Körpern mit Dicken von etwa 3 bis 10 μm und einem hohen Anteil ungerichteter Stengelkristallite mit Durchmessern von etwa 0,2 bis 1 μm und Längen von 20 bis 50 μm.

## Patentansprüche

1. Verfahren zur Herstellung oxidkeramischer, einkristalliner und/oder sich aus Einkristallen zusammensetzender in sich verbundener Körper, dadurch gekennzeichnet, daß ein oder mehrere oxidische Materialien, welches bzw. welche ein eutektisches, eutektoides oder peritektisches Phasensystem mit einem oder mehreren der Alkalimetall-Metall- und/oder Erdalkalimetall-Metall-Fluoride bildet bzw. bilden, mit ihm bzw. mit ihnen zusammen mit einem oder mehreren der Erdalkalimetall- und/oder Alkalimetall-Halogeniden in Form des Chlorids und/oder Bromids und/oder Jodids teilweise oder vollständig aufgeschmolzen wird bzw. werden, die gesamte Mischung nicht höher als 1300°C erwärmt und anschließend unter Erstarrung abgekühlt wird, und weiterhin die Halogenide mit Hilfe eines Lösungsmittels abgetrennt werden.

2. Verfahren nach Anspruch 1, dadurch gekennzeichnet, daß die Mischung so hergestellt wird, daß die Kationen der Schmelze zu mehr als 30%-mol aus denen der Alkalimetalle und/oder Erdalkalimetalle bestehen, und die Anionen zu mehr als 20%-mol aus denen des Chlors und/oder Broms und/oder Jods, und weniger als 80%-mol, aber mehr als 5%-mol, aus einem oder mehreren Anionen der Metall- Tri-, -Tetra-, -Penta- und/oder -Hexafluoride bestehen.

3. Verfahren nach Anspruch 2, dadurch gekennzeichnet, daß im wesentlichen nur die Kationen des Natriums und/oder des Kaliums verwendet werden.

4. Verfahren nach Anspruch 3, dadurch gekennzeichnet, daß Kalium- und/oder Natriumchlorid im Gewichtsverhältnis zum Kalium-Metall- und/oder Natrium-Metall-Tri- und/oder Tetra- und/oder Penta- und/oder Hexafluorid von 3/2 bis zu 2/3 verwendet wird.

5. Verfahren nach einem der vorhergehenden Ansprüche, dadurch gekennzeichnet, daß Natrium-Aluminiumhexafluorid (Kryolith) und/oder Kalium-Aluminiumhexafluorid verwendet wird.

6. Verfahren nach einem der vorhergehenden Ansprüche, dadurch gekennzeichnet, daß als oxidisches Material Aluminiumoxid und/oder Siliziumoxid und/oder Zirkonoxid und/oder Magnesiumoxid und/oder Kalziumoxid und/oder Titanoxid und/oder Cadmiumoxid und/oder Zinkoxid und/oder Chromoxid und/oder Vanadiumoxid und/oder Wolframoxid und/oder Molybdänoxid verwendet wird bzw. werden.

7. Verfahren nach einem der vorhergehenden Ansprüche, dadurch gekennzeichnet, daß die Schmelze abgeschreckt wird, und oxidkeramische, untereinander verbundene Platten, einzelne Lamellen und/oder Fasern erhalten werden, deren Dicke überwiegend weniger als 5 μm, vorzugsweise 0,1 bis 0,2 μm, beträgt und/oder oxidkeramische Körper erhalten werden, die Poren mit Durchmessern von überwiegend bis zu 5 μm aufweisen.

8. Verfahren nach einem der Ansprüche 1 bis 6, dadurch gekennzeichnet, daß die Schmelze mit einem Verhältnis des Temperaturgradienten zur Geschwindigkeit der Erstarrungsfront von mehr als 50°C h/cm$^2$ abgekühlt wird, so daß oxidkeramische Lamellen und/oder Fasern und/oder Whisker beliebiger Länge mit Wanddicken bzw. Durchmessern von überwiegend weniger als 10 μm, vorzugsweise weniger als 1 μm, erhalten werden.

9. Verfahren nach einem der vorhergehenden Ansprüche, dadurch gekennzeichnet, daß als Lösungsmittel Wasser oder ein wasserähnliches Lösungsmittel verwendet wird.

## Claims

1. Method for the manufacture of oxide ceramic bodies which are monocrystalline and/or composed of individual crystals and bonded within themselves characterized in that one or more oxidic materials which form a eutectic eutectoid or peritectic phase system with one or more of the alkali metal metal fluorides and/or alkaline earth metal metal fluorides are completely or partially fused therewith together with one or more of the alkaline earth metal halides and/or alkali metal halides in the form of chloride and/or bromide and/or iodide, the whole mixture is heated to not more than 1300°C and then cooled with solidification, and further the halides are separated by means of a solvent.

2. Method according to claim 1 characterized in that the mixture is prepared in such a way that the cations of the melt consist to the extent of more than 30%-mol of those of the alkali metals and/or alkaline earth metals and the anions consist to the extent of more than 20%-mol of those of the chlorine and/or bromine and/or iodine, and less than 80%-mol but more than 5%-mol of one or more anions of metal tri-, tetra-, penta- and/or hexafluorides.

3. Method according to claim 2 characterized in that essentially only the cations of sodium and/or potassium are used.

4. Method according to claim 3 characterized in that potassium and/or sodium chloride is used in a weight ratio from 3/2 to 2/3 to the potassium metal and/or sodium metal tri- and/or tetra- and/or penta- and/or hexafluoride.

5. Method according to any of the preceding claims characterized in that sodium aluminum hexafluoride (cryolite) and/or potassium aluminum hexafluoride is used.

6. Method according to any of the preceding claims characterized in that aluminum oxide and/or silicon oxide and/or zirconium oxide and/or magnesium oxide and/or calcium oxide and/or titanium oxide and/or cadmium oxide and/or zinx oxide and/or chromium oxide and/or vanadium oxide and/or tungsten oxide and/or molybdenum oxide is or are used as the oxidic material.

7. Method according to any of the preceding claims characterized in that the melt is quenched, and oxide ceramic mutually bonded plates, individual lamellas and/or fibers are obtained, whose thickness is predominantly less than 5 µm preferably 0.1 to 0.2 µm and/or oxide ceramic bodies are obtained which comprise pores with diameters of predominantly up to 5 µm.

8. Method according to any of claims 1 to 6 characterized in that the melt is cooled with a ratio of temperature gradient to speed of solid liquid interface of more than $50°C$ h/cm$^2$, so that oxide ceramic lamellas and/or fibers and/or whiskers of any length are obtained with wall thicknesses or diameters of mainly less than 10 µm preferably less than 1 µm.

9. Method according to any of the preceding claims characterized in that water or a water-like solvent is used as the solvent.

**Revendications**

1. Le procédé de fabrication de corps en céramique oxydées, monocristallins et/ou composé d'un assemblage de monocristaux, caractérisé par le fait qu'un ou plusieurs matériaux d'oxydation, présentant un système de phases eutectique, eutectoïde ou péritectique avec un ou plusieurs fluorures alcalino-métalliques ou alcalino-terreux-métalliques, sont portés à fusion totale ou partielle avec ceux-ci et avec un ou plusieurs haloïdes alcalino-terreux ou alcalins sous forme de chlorure et/ou bromure et/ou iodure, que le mélange global ne dépasse pas la température de 1300°C et que celui-ci est refroidi pour être solidifié, puis que l'haloïde est extrait du mélange à l'aide d'un dissolvant.

2. Procédé selon la revendication 1, caractérisé par le fait que le mélange est réalisé de façon à ce que les cations soient libérés par les métaux alcalins et/ou les alcalino-terreux dans la masse en fusion dans une proportion de plus de 30%-mol et que les anions soient libérés par le chlore et/ou le brome et/ou l'iode dans une proportion de plus de 20%-mol et par les tri-, tetra-, penta- et/ou hexafluorures métalliques dans une proportion comprise entre 5% et 80%-mol.

3. Procédé selon la revendication 2, caractérisé par le fait, que seuls les cations libérés par l'azote et/ou le potassium sont essentiellement employés.

4. Procédé selon la revendication 3, caractérisé par l'emploi du chlorure d'azote et/ou du chlorure de potassium dans un rapport de masses avec le tri-, tetra-, penta- et/ou hexafluorure de potassium-métallique et/ou de sodium-métallique équivalent à 3/2 jusqu'à 2/3.

5. Procédé selon une des revendications précédentes, caractérisé par l'emploi d'hexafluorure d'azote-aluminium (cryolithe) et/ou d'hexafluorure de potassium-aluminium.

6. Procédé selon une des revendications précédentes, caractérisé par l'emploi en tant que matériau à base d'oxydation d'oxyde d'aluminium et/ou oxyde de silicium et/ou oxyde de zirconium et/ou oxyde de magnésium et/ou oxyde de calcium et/ou oxyde de titane et/ou oxyde de cadmium et/ou oxyde de zinc et/ou oxyde de chrome et/ou oxyde de vanadium et/ou oxyde de tungstène et/ou oxyde de molybdène.

7. Procédé selon une des revendications précédentes, caractérisé par le trempage de la masse en fusion et par l'obtention de paillettes reliées entre elles, de lamelles isolées et/ou de fibres en céramique oxydée, dont les épaisseurs ne dépassent pas en général 5 µm, de préférence 0,1 à 0,2 µm, et/ou par l'obtention de corps de céramique oxydée, présentant des pores de diamètres allant en général jusqu'à 5 µm.

8. Procédé selon une des revendications 1 à 6 caractérisé par le refroidissement de la masse en fusion dans un rapport entre le gradient de température et la vitesse du front de solidification de plus de 50°C h/cm$^2$, de manière à ce qu'il y ait formation de lamelles et/ou de fibres et/ou de whiskers en céramique oxydée de longueur quelconque avec des épaisseurs de parois ne dépassant généralement pas 10 µm, de préférence inférieures à 1 µm.

9. Procédé selon une des revendications précédentes, caractérisé par l'emploi de l'eau comme dissolvant ou de dissolvants semblables à l'eau.